# EUROPÄISCHE PATENTSCHRIFT

(11) **EP 0 409 121 B1**
(45) Veröffentlichungstag und Bekanntmachung des Hinweises auf die Patenterteilung: **05.01.1994**
(21) Anmeldenummer: 90113532.7
(22) Anmeldetag: 14.07.1990
(51) Int. Cl.: C04B 35/00, H01L 39/24

(54) **Dichte, supraleitende Körper mit Textur**
Dense superconducting bodies with textured microstructure
Supraconducteurs denses à microstructure orientée

(30) Priorität: 19.07.1989 DE 3923845
(43) Veröffentlichungstag der Anmeldung: 23.01.1991
(73) Patentinhaber: HOECHST AKTIENGESELLSCHAFT, 65926 Frankfurt am Main (DE)
(72) Erfinder: Schwarz, Martin, Dr. rer. nat., D-6233 Kelkheim/Taunus (DE); Küllmer, Iris, D-6230 Frankfurt am Main (DE)

(56) Entgegenhaltungen:
- EP-A- 0 283 620
- EP-A- 0 300 353
- DE-A- 3 817 319

## Beschreibung

Die vorliegende Erfindung betrifft massive, oxidkeramische supraleitende Körper vom Typ YBa₂Cu₃O₇₋ₓ mit einer vorteilhaften Textur der Kristallite sowie ein Verfahren zu ihrer Herstellung.

Die jüngst aufgefundenen Hochtemperatur-supraleitenden Verbindungen auf der Basis von Y-Ba-Cu-O, Bi-Sr-Ca-Cu-O oder Tl-Ba-Ca-Cu-O versprechen hinsichtlich ihrer hohen kritischen Temperaturen T_{c} eine Vielzahl attraktiver Anwendungsmöglichkeiten. Nachteilig ist dabei, daß die für viele Anwendungen eines Massivkörpers (d. h. nicht in Form dünner Schichten) entscheidende Stromtragefähigkeit nur niedrige Werte aufweist. Als Grunde hierfür werden neben Verunreinigungen an den Korngrenzen ("weak links") vor allem die Tatsache angesehen, daß diese Supraleiter eine schichtartige Kristallstruktur aufweisen, die zu einer Anisotropie wichtiger physikalischer Eigenschaften führt. Beispielsweise hat man an Einkristallen von YBa₂Cu₃O₇₋ₓ nachgewiesen, daß unter Bedingungen der Supraleitung Ströme nur in einer Ebene fließen, die senkrecht zur Gitterachse c verläuft. Der Stromfluß wird deshalb verbessert, wenn die einzelnen Kristalle langgestreckt sind.

Es bestand daher die Aufgabe, massive Supraleiter zu schaffen, bei denen zumindest die kristallinen Bereiche langgestreckt sind.

Die Erfindung löst diese Aufgabe. Sie beruht auf der Erkenntnis, daß beim Sintern eines Supraleiter-Pulvers der Zusammensetzung YBaCu₃O₇₋ₓ, das Additiv CuO die Ausbildung texturierter Proben (d.h. Proben mit paralleler Ausrichtung einkristalliner Lamellen) begünstigt und diese Proben eine besonders hohe Dichte aufweisen.

Gegenstand der Erfindung sind massive Supraleiter der Bruttozusammensetzung YBa₂Cu₃O₇₋ₓ·zCuO wobei z eine Zahl von 0,08 bis 0,84 ist, die aus langgestreckten, miteinander regellos verwachsenen Kristallen bestehen und eine Dichte von mindestens 5,9 g/cm³ aufweisen. Das Additiv CuO scheint die günstigen Eigenschaften des Supraleiters geringfügig zu verbessern; es ist jedoch insbesondere erforderlich, um zu erreichen, daß die einzelnen kristallinen Bereiche eine langgestreckte Textur aufweisen.

Wenn man dagegen ein feines Pulver aus YBa₂Cu₃O₇₋ₓ in Abwesenheit von Additiven zu dichten Körpern sintert, so ist deren Gefüge hinsichtlich der Größe und Form und Richtung der Körner völlig regellos aufgebaut. Insbesondere bestehen die Körner aus kleinen, unregelmäßig geformten kristallinen Bereichen mit Anteilen amorpher Bereiche. Ohne Zugabe von Fremdstoffen werden Sinterproben mit Dichten bis 98 % der theoretischen Dichte erhalten, sofern ein bestimmtes Sinterprogramm (vgl. Beispiel 1 aber ohne CuO) eingehalten wird.

Der Anteil des Additivs Kupferoxid liegt insbesondere bei 0,16 - 0,50 Mol pro Mol YBa₂Cu₃O₇₋ₓ. Bei diesen Zusätzen weisen die Kristalle der Supraleiter im Mittel ein Verhältnis von Länge/Durchmesser von 3:1 - 10:1 auf.

Die erfindungsgemäßen Supraleiter lassen sich dadurch herstellen, daß man ein feinkörniges Supraleiterpulver der Zusammensetzung YBa₂Cu₃O₇₋ₓ mit 1 bis 10 Gew.-% Kupferoxid mischt, die Mischung unter einen Druck von mindestens 1 MPa zu einem Formkörper verformt und diesen mindestens eine Stunde, noch besser mindestens 5 Stunden, bei 940 bis 985°C, insbesondere 950 bis 975°C zum Sintern erhitzt. Besonders regelmäßige anisotrope Kristalle werden gebildet mit Zusätzen von 2 - 6 Gew.-% CuO. Die Bruttozusammensetzung des erhaltenen Produkts entspricht der der Ausgangsmischung.

Überraschenderweise ist die Dichte der so hergestellten Körper besonders hoch. Die Dichte erfindungsgemäßer supraleitender Formkörper der Zusammensetzung YBa₂Cu₃O₇₋ₓ·zCuO liegt bei mindestens 95 %, meist bei mindestens 98 % der theoretischen Dichte von 6.344. Im allgemeinen bilden sich massive Formkörper mit einer Dichte von 6,02 - 6,22 g/cm³ entsprechend 95-98 % der Theorie. Diese hohe Dichte führt zu einer besonders hohen mechanischen Belastbarkeit der Körper.

Das angegebene Verfahren erlaubt erstmals die Herstellung besonders dichter Proben (mit > gt; 98 %, insbesondere 98 - 99 % der theoretischen Dichte) in einem relativ breiten Temperaturbereich. So ist der für die Sintertemperatur einzuhaltende Bereich 950-980°C, besonders vorteilhaft 970° bis 980°C.
Das zugesetzte CuO soll möglichst fein gemahlen sein. Vorteilhaft ist eine mittlere Korngröße von maximal 100 µm. Unabhängig vom Anteil an zugegebenem CuO, eingesetztem YBa₂Cu₃O₇₋ₓ-Pulver und gewähltem Sinterprogramm liegen die Dichten der Proben höher, wenn statt grobem CuO fein gemahlenes CuO verwendet wird.

Ein alternativer Herstellungsprozeß geht aus von einem zur Bildung eines Supraleiters führenden Gemisch der Ausgangskomponenten, wie z. B. der betreffenden Metalloxide, -carbonate oder -nitrate, dem ein Überschuß an CuO zugesetzt wird und das in analoger Weise zur Reaktion gebracht wird. Dabei tritt fast immer mindestens teilweise eine schmelzflüssige Phase auf. Wahrscheinlich ist diese schmelzflüssige Phase verantwortlich für die Ausbildung zusammenhängender kristalliner Bereiche. Dieses Erhitzen zum Sintern dauert mindestens zwei Stunden, vorzugsweise mindestens 10, insbesondere mindestens 20 Stunden.

In allen Fällen ist es vorteilhaft, wenn man das Erhitzen in einer Atmosphäre vornimmt, die freien Sauerstoff enthält. Es ist ferner vorteilhaft, wenn man nach dem Sintern auf eine Temperatur von 400°C oder höher abkühlt, bei der keine flüssige Phase mehr vorhanden ist, beispielsweise auf Temperaturen von 880 bis 900°C, und man den Ansatz bei dieser Temperatur in Gegenwart einer Sauerstoff enthaltenden Atmosphäre mindestens eine Stunde, vorzugsweise aber mindestens 5 Stunden hält. Besonders bevorzugt ist es, wenn die Dauer des Erhitzens in beiden Stufen im Bereich von 10 bis 20 Stunden, vorzugsweise bei 15 Stunden liegt.

Die Produkte, die nach diesem Verfahren erhalten werden, weisen bessere supraleitende Eigenschaften auf als Proben ohne CuO. So liegen die kritischen Temperaturen im Bereich von 90 K, d.h. etwa 4K höher als bei Proben ohne CuO. Auch die Stromtragfähigkeit ist gut.

Die Erfindung wird durch die Beispiele und die zugehörigen Bilder (aufgenommen mit linear polarisiertem Licht, Vergrößerung 460- bzw. 1700-fach) näher erläutert.

### Beispiel 1

Feinkörniges YBa₂Cu₃O₇₋ₓ-Pulver wird mit 2 % CuO (feinkörnig) vermischt, unter einem Druck von ca. 300 MPa (3 kbar) zu Formkörpern gepreßt und folgendermaßen an Luft gesintert:
Aufheizen in 10 h auf 975°C
20 h Tempern bei 975°C
Abkühlen in 10 h auf 400°C
15 h Tempern bei 400°C
Abkühlen in 4 h auf Raumtemperatur (= RT)
Ergebnis:
- Dichte: : 6.32 g/cm³ (99.6 % d. theor. Dichte)
- Tc: : 90K
- mittlere Kornlänge: : e = 35 µm
- mittlere Kornbreite: : d = 4 µm

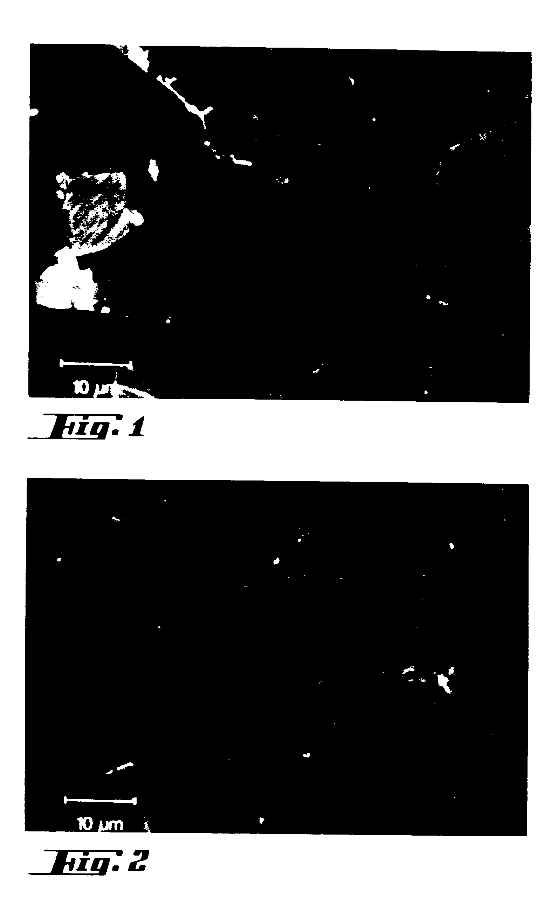

Eine Gefügeaufnahme ist dargestellt im Bild 1.
Das Bild zeigt mehrere einkristalline Lamellen aus HTSL-Material, die aber nur in geringem Maße parallel zueinander ausgerichtet sind.

### Beispiel 2

Feinkörniges YBa₂Cu₃O₇₋ₓ-pulver wird mit 5 % CuO (feinkörnig) wie in Beispiel 1 zu einem grünen Formkörper verarbeitet und dieser wie folgt gesintert:
Aufheizen in 10 h auf 975°C
20 h Tempern bei 975°C
Abkühlen in 10 h auf 400°C
15 h Tempern bei 400°C
Abkühlen in 5 h auf RT
Ergebnis:
- Dichte: : 6.33 g/cm³ (99.7 % d. theor. Dichte)
- Tc: : 90K

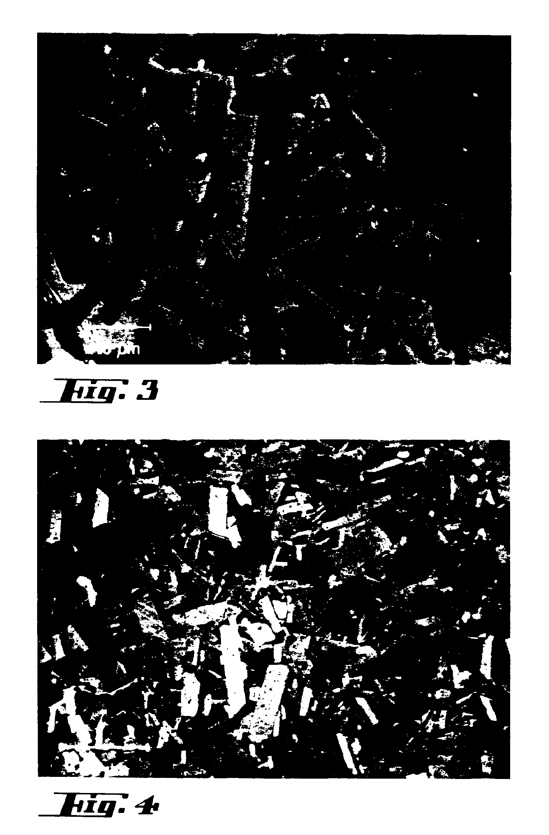

e = 40 µm
d = 4 µm
Eine Gefügeaufnahme ist dargestellt im Bild 2.
Man erkennt im Bild, daß die einkristallinen Bereiche schmaler und länglichere Formen aufweisen und auch stärker parallel zueinander ausgerichtet sind als bei Beispiel 1.

### Beispiel 3

Feinkörniges YBa₂Cu₃O₇₋ₓ-pulver wird mit 10 % CuO (feinkörnig) wie in Beispiel 1 zu einem grunen Formkörper verarbeitet und dieser wie folgt gesintert:
Aufheizen in 10 h auf 975°C
20 h Tempern bei 975°C
Abkühlen in 10 h auf 400°C
15 h Tempern bei 400°C
Abkühlen in 5 h auf RT
Ergebnis:
- Dichte: : 6.32 g/cm³ (99.6 % d. theor. Dichte)
- Tc: : 88 K

e = 35 µm
d = 5 µm
Eine Gefügeaufnahme ist dargestellt im Bild 3.
HTSL-Kristalle sind zwar schön kristallisiert, aber nicht parallel zueinander ausgerichtet. Grund: ein Teil des Additives CuO scheidet sich zwischen den HTSL-Kristallen aus und unterbindet deren Kontakt untereinander.

### Beispiel 4

Feinkörniges YBa₂Cu₃O₇₋ₓ wird mit 5 % CuO (feinkörnig) wie in Beispiel 1 zu einem grünen Formkörper verarbeitet und dieser wie folgt gesintert:
Aufheizen in 10 h auf 950°C
20 h Tempern bei 950°C
Abkühlen in 10 h auf 400°C
15 h Tempern bei 400°C
Abkühlen in 5 h auf RT
Ergebnis:
- Dichte: : 6.30 g/cm³ (99.3 % d. theor. Dichte)
- Tc: : 90 K

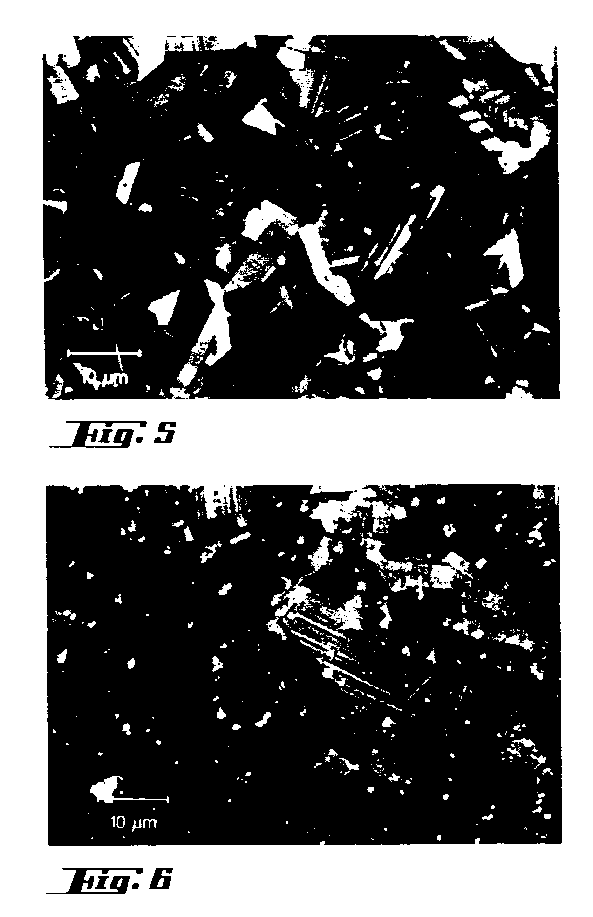

e = 30 µm
d = 5 µm
Eine Gefügeaufnahme ist dargestellt im Bild 4.
Beim Vergleich mit Beispiel 2 (Sindertemperatur ca. 975°C) erkennt man, daß die Ausbildung größerer einkristalliner, länglicher Bereiche und deren parallele Ausrichtung an einen charakteristischen Temperaturbereich gebunden ist, der hier nicht eingehalten wurde. Kristalle sind in diesem Beispiel sehr kleinflächig, weisen kaum eine Vorzugsrichtung auf und sind nicht parallel zueinander angeordnet.

### Beispiel 5

Feinkörniges YBa₂Cu₃O₇₋ₓ-Pulver wird mit 5 % CuO (fein) wie in Beispiel 1 zu einem grünen Formkörper verarbeitet und dieser wie folgt gesintert:
Aufheizen in 10 h auf 975°C
10 h Tempern bei 975°C
Abkühlen in 10 h auf 400°C
15 h Tempern bei 400°C
Abkühlen in 5 h auf RT
Ergebnis:
- Dichte: : 6.33 g/cm³ (99.7 % d. theor. Dichte)
- Tc: : 88 K

e = 40 µm
d = 4 µm
Eine Gefügeaufnahme ist dargestellt im Bild 5.
Der Ansatz entspricht Beispiel 2. Die Haltezeit bei der Maximaltemperatur wurde halbiert. Gefüge entspricht dennoch Beispiel 2. Dies zeigt, daß die Ausbildung der Textur ein relativ schneller Vorgang ist und nach wenigen Stunden abgeschlossen ist.

### Beispiel 6 (Vergleichsbeispiel)

Feinkörniges YBa₂Cu₃O₇₋ₓ-Pulver wird mit 5 % CuO (grobkörnig) wie in Beispiel 5 zu einem Sinterkörper verarbeitet.
Ergebnis:
- Dichte: : 5.58 g/cm³ (88 % d. theor. Dichte)
- Tc: : 88 K

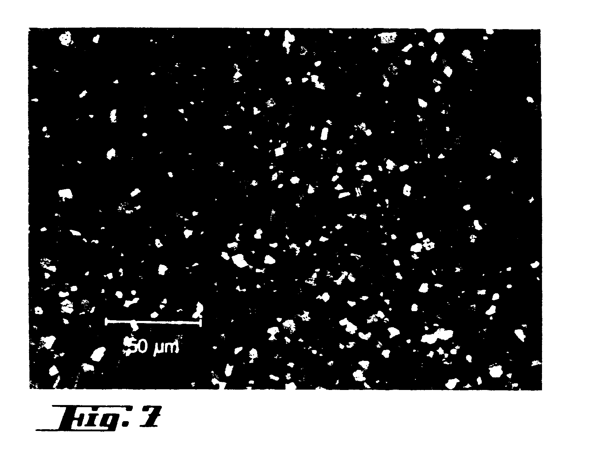

e = 30 µm
d = 5 µm
Eine Gefügeaufnahme ist dargestellt im Bild 6.

Man erkennt, daß Größe und Parallelausrichtung der einzelnen Kristalle geringer ist als in der Vergleichsprobe mit feinem CuO. Dieses Gefügebild zeigt, daß der Texturierungseffekt von CuO nicht nur eine Funktion des prozentualen Gehaltes des Additives oder des Temperaturprogrammes ist, sondern auch davon abhängt, ob CuO feinkörnig oder - wie hier - grobkristallin zugesetzt wird.

### Beispiel 7 (Vergleichsbeispiel)

Feinkörniges Pulver (YBa₂Cu₃O₇₋ₓ) wird ohne Additiv wie in Beispiel 5 zu einem Sinterkörper verarbeitet. Jedoch wird 20 Stunden bei 975°C getempert.
Ergebnis:
- Dichte: : 6.23 g/cm³ (98,2 % d. theor. Dichte)
- Tc: : 60 K

Eine Gefügeaufnahme ist dargestellt im Bild 7.
Das Gefüge ist kleinkristallin, porös und die Kristalle weisen keine Vorzugsrichtung auf.

## Patentansprüche (Patentansprüche für folgende(n) Vertragsstaat(en): AT, BE, CH, LI, DE, FR, GB, IT, LU, NL, SE)

1. Massiver Supraleiter der Bruttozusammensetzung YBa₂Cu₃O₇₋ₓ·zCuO, wobei z eine Zahl von 0,08 bis 0,84 ist, der aus langgestreckten, miteinander regellos verwachsenen Kristallen besteht und eine Dichte von mindestens 5,9 g/cm³, insbesondere mindestens 6,02 g/cm³ aufweist.

2. Supraleiter gemäß Anspruch 1, dadurch gekennzeichnet, daß in den Kristallen das Verhältnis Länge/Durchmesser im Mittel bei 3:1 bis 10:1 liegt.

3. Supraleiter gemäß Anspruch 1, dadurch gekennzeichnet, daß er eine Dichte von 6,00 bis 6,33 g/cm³ aufweist.

4. Verfahren zur Herstellung eines Supraleiters gemäß Anspruch 1, dadurch gekennzeichnet, daß man ein feinkörniges Supraleiterpulver der Zusammensetzung YBa₂Cu₃O₇₋ₓ mit 1 bis 10 Gew.-% CuO mischt, die Mischung unter einen Druck von mindestens 1 MPa zu einem Formkörper verformt und diesen mindestens 5 Stunden bei 940-985°C, insbesondere 950-975°C erhitzt.

5. Verfahren gemäß Anspruch 4, dadurch gekennzeichnet, daß man das Erhitzen in einer Atmosphäre vornimmt, die freien Sauerstoff enthält.

## Patentansprüche (Patentansprüche für folgende(n) Vertragsstaat(en): ES, GR)

1. Verfahren zur Herstellung eines massiven Supraleiters der Bruttozusammensetzung YBa₂Cu₃O₇₋ₓ·zCuO, wobei z eine Zahl von 0,08 bis 0,84 ist, dadurch gekennzeichnet, daß man ein feinkörniges Supraleiterpulver der Zusammensetzung YBa₂Cu₃O₇₋ₓ mit 1 bis 10 Gew.-% CuO mischt, die Mischung unter einem Druck von mindestens 1 MPa zu einem Formkörper verformt und diesen mindestens 5 Stunden bei 940-985°C, insbesondere 950-975°C erhitzt.

2. Verfahren gemäß Anspruch 1, dadurch gekennzeichnet, daß man das Erhitzen in einer Atmosphäre vornimmt, die freien Sauerstoff enthält.

## Claims (Claims for the following Contracting State(s): AT, BE, CH, DE, FR, GB, IT, LI, LU, NL, SE)

1. A compact superconductor of the empirical composition YBa₂Cu₃O₇₋ₓ × zCuO, in which z is a number from 0.08 to 0.84, which consists of elongated crystals grown together irregularly and has a density of at least 5.9 g/cm³, in particular at least 6.02 g/cm³.

2. A superconductor as claimed in claim 1, wherein the ratio of length/diameter in the crystals is on average 3:1 to 10:1.

3. A superconductor as claimed in claim 1, which has a density of 6.00 to 6.33 g/cm³.

4. A process for the preparation of a superconductor as claimed in claim 1, wherein a fine-grained superconductor powder of the composition YBa₂Cu₃O₇₋ₓ is mixed with 1 to 10% by weight of CuO, the mixture is molded under a pressure of at least 1 MPa to give a molding, and this molding is heated at 940-985°C, in particular 950-975°C, for at least 5 hours.

5. The process as claimed in claim 4, wherein the heating is carried out in an atmosphere which contains free oxygen.

## Claims (Claims for the following Contracting State(s): ES, GR)

1. A process for the preparation of a compact superconductor of the empirical composition YBa₂Cu₃O₇₋ₓ × zCuO, in which z is a number from 0.08 to 0.84, wherein a fine-grained superconductor powder of the composition YBa₂Cu₃O₇₋ₓ is mixed with 1 to 10% by weight of CuO, the mixture is molded under a pressure of at least 1 MPa to give a molding, and this molding is heated at 940-985°C, in particular 950-975°C, for at least 5 hours.

2. The process as claimed in claim 1, wherein the heating is carried out in an atmosphere which contains free oxygen.

## Revendications (Revendications pour l'(les) Etat(s) contractant(s) suivant(s): AT, BE, CH, LI, DE, FR, GB, IT, LU, NL, SE)

1. Supraconducteur massif de composition brute YBa₂Cu₃O₇₋ₓ.zCuO, où z est un nombre de 0,8 à 0,84, constitué de cristaux allongés, irrégulièrement imbriqués les uns dans les autres, et présentant une masse volumique d'au moins 5,9 g/cm³ et, en particulier, d'au moins 6,02g/cm³.

2. Supraconducteur selon la revendication 1, caractérisé en ce que, dans les cristaux, le rapport longueur/diamètre est en moyenne de 3:1 à 10:1.

3. Supraconducteur selon la revendication 1, caractérisé en ce qu'il a une masse volumique de 6,00 à 6,33 g/cm^{3.}

4. Procédé pour préparer un supraconducteur selon la revendication 1, caractérisé en ce qu'on mélange une poudre supraconductrice à fine granulométrie ayant la composition YBa₂Cu₃O₇₋ₓ à une quantité de 1 à 10 % en poids de CuO, on transforme le mélange en un comprimé sous une pression d'au moins 1 MPa, et on chauffe ce dernier pendant au moins 5 heures à une température de 940 à 985°C et, plus particulièrement, de 950 à 975°C.

5. Procédé selon la revendication 4, caractérisé en ce qu'on procède au chauffage dans une atmosphère contenant de l'oxygène libre.

## Revendications (Revendications pour l'(les) Etat(s) contractant(s) suivant(s): ES, GR)

1. Procédé pour préparer un supraconducteur massif ayant la composition brute Yba₂Cu₃O₇₋ₓ.zCuO, où z est un nombre de 0,08 à 0,84, caractérisé en ce qu'on mélange une poudre supraconductrice à fine granulométrie ayant la composition YBa₂Cu₃O₇₋ₓ à une quantité de 1 à 10 % en poids de CuO, on transforme le mélange en un comprimé sous une pression d'au moins 1 MPa, et on chauffe ce dernier pendant au moins 5 heures à une température de 940 à 985°C et, plus particulièrement, de 950 à 975°C.

2. Procédé selon la revendication 1, caractérisé en ce qu'on procède au chauffage dans une atmosphère contenant de l'oxygène libre.
